# EUROPEAN PATENT SPECIFICATION

(11) **EP 1 112 675 B1**
(45) Date of publication and mention of the grant of the patent: **03.03.2004**
(21) Application number: 99949503.9
(22) Date of filing: 08.09.1999
(51) Int. Cl.: H05K 13/00

(54) **SUPPORTING DEVICE FOR MOUNTING COMPONENTS ON A PRINTED CIRCUIT BOARD**
BEFESTIGUNGSVORRICHTUNG ZUR BESTÜCKUNG VON LEITERPLATTEN MIT BAUELEMENTEN
DISPOSITIF DE FIXATION POUR SUPPORTER DES COMPOSANTS SUR UNE CARTE DE CIRCUITS IMPRIMES

(30) Priority: 11.09.1998 SE 9803085
(43) Date of publication of application: 04.07.2001
(73) Proprietor: ASCOM TATECO AB, 402 76 Göteborg (SE)
(72) Inventor: KLEMETS, Tomas, S-433 34 Partille (SE)
(86) International application number: PCT/SE1999/001562
(87) International publication number: WO 2000/016600

(56) References cited:
- US-A- 4 770 455
- US-A- 5 120 033
- US-A- 5 157 438
- US-A- 5 364 083
- US-A- 5 722 646

## Description

### Field of the Invention

The present invention relates to a supporting device when mounting components on a printed circuit board. The supporting device comprises a plurality of elongate supporting elements, which are arranged transversely of the plane of the printed circuit board to support the printed circuit board during mounting and adapted to be movable and yieldingly displaceable towards the printed circuit board to form a fixture for supporting the printed circuit board.

### Background Art

In automatic mounting of components on a printed circuit board, the printed circuit board is conveyed on conveyors which support the printed circuit board merely on the edges thereof. When components are being put in place on the printed circuit board, there is thus a risk that the card is hit or pressed down and springs up, which may result in components which have already been put in place being moved out of their correct position (the so-called Manhattan effect).

A solution to this problem is to arrange under the printed circuit board a form or fixture which supports the printed circuit board under its entire surface and thus distributes forces uniformly over the printed circuit board. In many cases, for instance when mounting on both sides, where components have already been mounted on the underside of the printed circuit board, the undersides of the printed circuit boards, however, do not have an identical topography, i.e. downwardly directed contour, which means that the form or fixture must be exchanged for each new series of printed circuit boards.

A different solution is to arrange supporting pins of a fixed length, provided with magnetic feet, in a pattern conforming with the type of printed circuit board at issue. The pins can be placed on a lifting table which is raised towards the printed circuit board before starting the mounting of components, and consequently forces exerted on the printed circuit board are distributed among all the supporting pins.

If components have already been mounted on the underside of the printed circuit board, the supporting pins must be arranged between the components so as to hit a free printed circuit board surface. If a supporting pin hits a component, this can in fact result in the printed circuit board bulging upwards or the component or the printed circuit board being damaged, which in both cases is unacceptable. A printed circuit board with many components can have a very small free surface, which means that only a small number of supporting pins can be made to abut against the printed circuit board, and thus only a limited degree of pressure equalisation can be accomplished.

US-A-5157438 discloses a supporting device according to the prior art portion of claim 1.

The above prior art solutions involve difficulties in achieving a high degree of utilisation of the mounting machinery since fixtures or supporting pins must be exchanged or shifted each time the production of a new series of printed circuit boards is begun.

### Summary of the Invention

An object of the present invention is to solve the above problems and provide a device for mounting components on a printed circuit board, which are automatically adapted to the downwardly directed topography of each printed circuit board.

According to the invention, this object is achieved by a device of the type stated by way of introduction, wherein the supporting elements are lockable in any desired position, independency of the topography of the printed circuit board, so that the fixture forming when the supporting element contacts the printed circuit board or components mounted on the printed circuit board can be fixed so as to provide optimal support for the printed circuit board during mounting.

The supporting elements, which are distributed in an area which essentially corresponds to the size of the printed circuit board, are moved towards the printed circuit board and thus form a supporting fixture which is a "cast" of the underside of the printed circuit board at issue. Since the supporting elements are yieldingly displaceable towards the printed circuit board and thus adapt their length so as to exactly reach the printed circuit board or a component mounted thereon, the pressure exerted on the printed circuit board in connection with the mounting of a component is distributed among all the supporting elements which support the printed circuit board, also those which are moved towards components that have already been mounted. For each new printed circuit board, the supporting elements can be returned to the initial position and then be moved towards the new printed circuit board, thus automatically adapting the supporting fixture to a new type of printed circuit board.

The supporting elements are suitably adapted to be movable in the direction of the printed circuit board by fluid action, preferably by hydraulic or pneumatic action. Preferably the fluid is a gas, such as compressed air.

Furthermore the supporting elements suitably communicate with a common, closed space, so that, when the space is subjected to a predetermined fluid pressure, all supporting elements rise in the direction of the printed circuit board. With this type of resilience, the pressure on the printed circuit board is uniformly distributed among all the supporting elements independently of how far a supporting element protrudes towards the printed circuit board or a component mounted thereon, so that a supporting element that has been moved towards a mounted component is not subjected to greater pressure or causes the printed circuit board to bulge upwards. Pressing down a supporting element in fact results in an increase of the pressure in the closed space and, consequently, on all supporting elements. The punctiform increase in pressure thus is distributed among all the supporting elements.

According to an embodiment, the locking of the supporting elements is preferably effected by means of a plurality of plates which are located in planes parallel with the printed circuit board and are displaceable in their respective planes and which have through holes through which the supporting elements run so that, when the plates are displaced relative to each another, the supporting elements are clamped and locked.

A resilient frictional element, such a rubber plug, can be arranged in connection with each hole in the plates so that, when the plates are displaced relative to each other, the supporting elements are clamped and locked between two frictional elements. When the plates are again put into the starting position and the contact between the supporting elements and the frictional elements ceases, the supporting element once more run freely in the holes and can be returned to the lowered position.

The supporting elements may consist of hollow, stationary supports and hollow pins which are closed at their free end, the pins being movably arranged adjacent to the supports transversely of the plane of the printed circuit board. This results in a reduction of the mass moved towards the printed circuit board when using the supporting device since only the hollow pins are contacted with the printed circuit board. In other words, the impact resulting from the contact of the supporting elements with the printed circuit board or components mounted on the printed circuit board will be very small, and only a small degree of kinetic energy and a small degree of motion are transferred to the printed circuit board. This reduces the risk of damage to the printed circuit board and the components.

Furthermore the pins may in their lower part have an abutment means, preferably a flange, which restricts the freedom of motion of the pins by abutting, in a predetermined position, against an abutment intended therefor. In this manner, it is ensured that the pins do not come loose from the supporting device in the case where no printed circuit board restricts their motion.

### Brief Description of the Drawings

A preferred embodiment of the invention will now be described with reference to the accompanying drawings, in which
Fig. 1 is schematic side view of part of a supporting device according to the invention and part of a printed circuit board supported on the same,
Fig. 2 illustrates the part of the supporting device shown in Fig. 1 in the initial position,
Fig. 3 is a top plan view of the part of the supporting device shown in Fig. 2, and

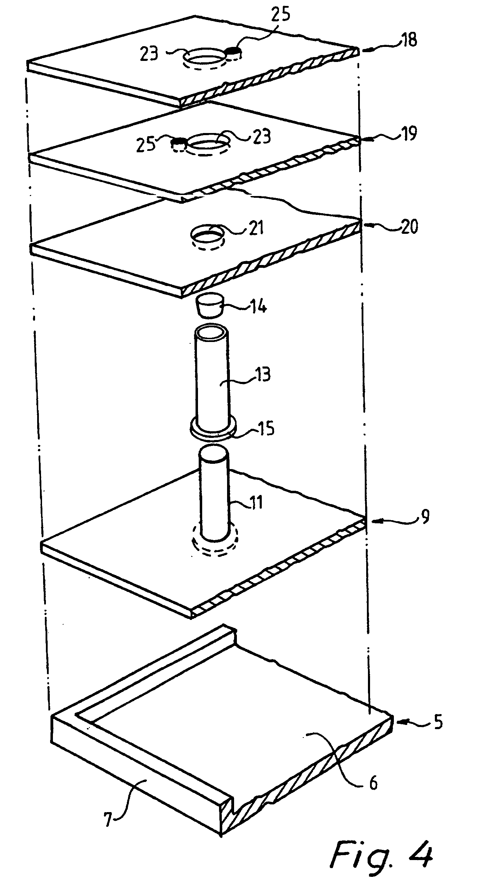

Fig. 4 is an exploded view of an area round a supporting element of the supporting device shown in Figs 1-3.

### Description of a Preferred Embodiment

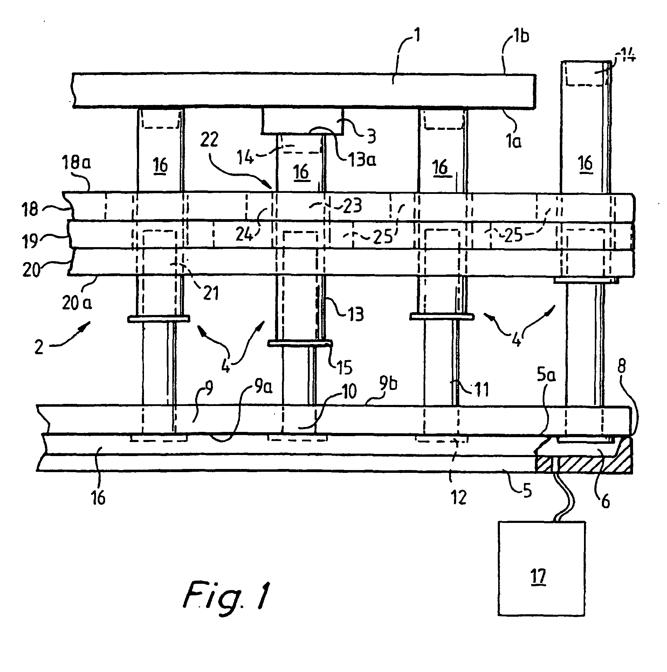

The printed circuit card 1 in Fig. 1 rests with its underside 1a against a supporting device 2 according to the invention. A number of components 3 have already been mounted on the underside 1a of the printed circuit board, and the appearance of the topography of the underside therefore is complicated. The supporting device 2 supports the printed circuit board 1 by means of a plurality of supporting elements 4.

The base plate 5 of the supporting device 2 is made of, for example, aluminium or some other suitable material and has in its upper side 5a a recess 6, formed by, for example, milling, inside its outer edge 7. Between the edge 7 and the recess 6 there is a sealing element, suitably a packing 8 or jointing compound. A top plate 9 having essentially the same surface as the base plate 5 is fixedly arranged above the base plate 5 so that the recess 6 thus is enclosed by the plates 5, 9.

The top plate 9 has through holes 10 in connection with which tubes 11 having essentially the same diameter as the holes 10 have been attached in order to communicate through the holes with the recess 6. In the shown embodiment, each tube 11 has a flanqe 12 in its lower edge, and each tube 11 is inserted from below through the associated hole 10 so that the flange 12 is positioned on the underside 9a of the plate 9. Then the tubes 11 are glued, soldered or attached in some other sealing fashion to the plate 9.

A hollow pin 13 is slipped on to each tube 11, said pin 13 having an inner diameter which is essentially the same as, or slightly greater than, the outer diameter of the tube. The upper end 13a of the pin 13 facing away from the base plate 5 is closed, for example by means of a plug 14 or the like, and at the opposite end there is formed an abutment means, in the case shown an outwardly directed flange 15.

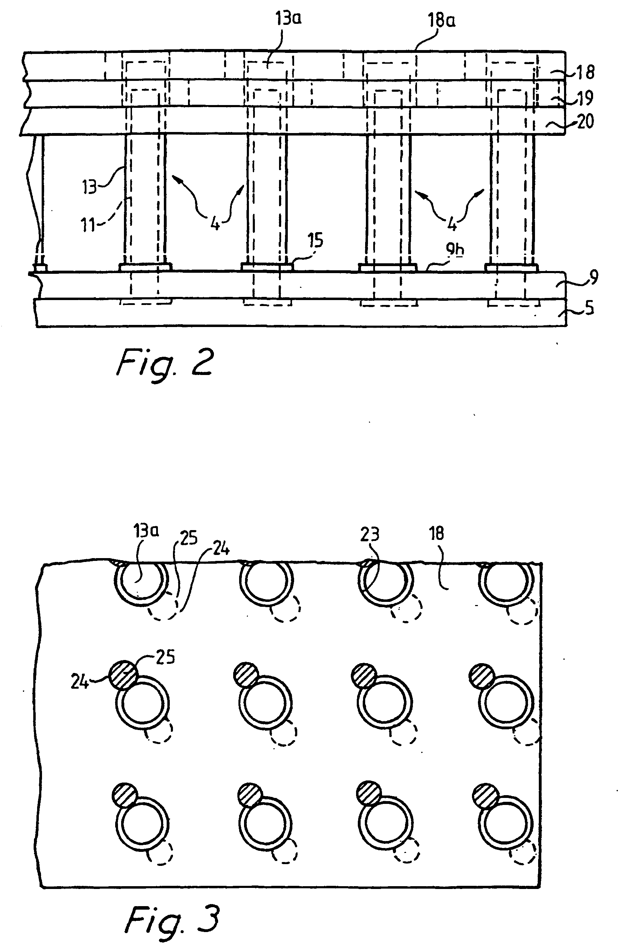

The tubes 11 and the pins 13 may consist of, for instance, tubular brass rivets having a diameter of about 5 mm, but also other materials and dimensions can be used. In the preferred embodiment, the pins 13 are positioned in a square checked pattern, either about 20 mm or about 10 mm from each other (see Fig. 3).

A substantially air-tight space 16 is thus formed of the recess 6 between the plates 5, 9 and the tubes 11 closed by means of the pins 13. A means 17 for supplying compressed air is connected to the space 16 for generating sub-atmospheric pressure, and the space may expand by the pins 13 moving upwards along the tubes 11.

In planes parallel with the plates 5, 9 and spaced apart therefrom, in the case shown, above the same, three plates 18, 19, 20 are arranged. In the shown case, all three plates 18, 19, 20 have the same number of holes 21, 22 as the number of pins 13, said holes 21, 22 being positioned so as to allow the pins 13 to run through all three plates. The distance between the lower plate 20 and the top plate 9 is smaller than the length of a pin, and preferably, the distance is such that each pin 13 extends from the top plate 9 and through the three plates 18, 19, 20. so that the upper end 13a of the pin is positioned essentially on a level with (in the case shown, somewhat below, see Fig. 2) the upper side 18a of the upper plate 18.

The holes 21 in the lower of the three plates 20 are formed with a diameter which preferably is only somewhat greater than the outer diameter of the pins. Each hole 22 in the two upper plates 18, 19 is formed of a large hole 23 and a small hole 24, which partially goes into the hole 23. Through the large hole runs the associated pin 13, and in the small hole a resilient frictional element, such as a plug 25 of rubber or like material, has been inserted. The plugs 25 are arranged on opposite sides of the respective pins 13.

The function of the device will now be described. On a convenient occasion, preferably when the printed circuit board 1 has been inserted in the mounting machine (not shown), the supporting device mounted on a lifting table (not shown) is moved in the direction of the printed circuit board 1 until a distance corresponding to less than the entire length of a pin 13, preferably approximately half the length of a pin, separates the underside 1a of the printed circuit board from the upper end 13a of the pins. Each pin is in its lowermost position and rests with its flange 15 against the upper side 9b of the top plate 9 (see Fig. 2).

Then the space 16 is supplied with pressure above atmospheric. The space 16 then tries to expand, the pins 13 rising towards the printed circuit board 1. A pin impinging on a possible component 3 on the underside 1a of the printed circuit board 1 is prevented from moving upwards, and another pin that does not meet with any resistance, for example owing to a hole in the printed circuit board or the fact that it is positioned outside the printed circuit board, is finally prevented from moving upwards by the flange 15 hitting the underside 20a of the plate 20 (see Fig. 1).

Since all pins 13 communicate directly with the common space 16, all pins 13 that impinge on the printed circuit board 1 or a component 3 will be pressed against the same by the same pressure independently of the position of projection.

When the pins 13 have contacted the printed circuit board 1, they are locked in this position by the plates 18, 19 being displaced relative to each other, for instance, by pneumatic or mechanical action. The rubber plugs 25 are thus contacted with the pins 13 and clamp these and prevent them from being pressed down.

The printed circuit board now rests on a fixture of pins 13, and components can be mounted on the upper side 1b of the printed circuit board 1, the fixture ensuring that forces acting on the printed circuit board are uniformly distributed over the entire surface thereof.

When the mounting of components on the printed circuit board is terminated, the plates 18, 19 are returned to their initial position, and the contact between the pins 13 and the rubber plugs 25 ceases. Thus, the pins again run freely in the holes 23 and can, by decreasing the pressure in the space 16, be returned to the original, lowered position.

It will be appreciated that the embodiment described above should be considered merely an exemplification of the inventive concept defined in the appended claims. The choice of material, sizes and shapes that appear in the specification and that are not of essential importance to the invention may be varied. For example, the plates 5, 9, 18, 19, 20 could consist of epoxy, and the pins 13 and the tubes 10 could be made of rigid plastic.

Instead of compressed air, a different gas or liquid could be used.

The expression "transversely of the plane of the printed circuit board" can, like in the shown embodiment, mean a direction essentially at right angles to the plane of the printed circuit board, but is not restricted to this interpretation in the present application. Thus, the supporting elements could be movable in an arbitrary direction that intersects the plane of the printed circuit board, and all supporting elements need not necessarily be arranged in parallel with each other.

Reference directions, i.e. upwards, downwards, upper side etc, that appear in this document are selected according to the accompanying Figures, which illustrate an embodiment of the invention. With a different orientation of the invention, where, for instance, a printed circuit board is laterally pressed onto an abutment, these reference directions could thus have a different designation.

## Claims

1. A supporting device (2) when mounting components (3) on a printed circuit board (1), comprising a plurality of elongate supporting elements (4), which are arranged transversely of the plane of the printed circuit board to support the printed circuit board when mounting the components and adapted to be movable and yieldingly displaceable towards the printed circuit board (1) to form a fixture for supporting the printed circuit board, **characterised in that** the supporting elements (4) are lockable in any desired position in dependence on the topography of the printed circuit board (1).

2. A supporting device as claimed in claim 1, **characterised in that** the supporting elements (4) are adapted to be displaceable towards the printed circuit board by fluid action, preferably liquid pressure or gas pressure.

3. A supporting device as claimed in claim 2, **characterised in that** the fluid is a gas, preferably compressed air.

4. A supporting device as claimed in claim 2 or 3, **characterised in that** the supporting elements (4) communicate with a common, closed space (6, 16) so that, when the space is subjected to fluid pressure, all supporting elements rise, under the action of pressure, in the direction of the printed circuit board (1).

5. A supporting device as claimed in any one of the preceding claims, **characterised by** at least one locking element (18, 19) which is displaceable essentially transversely of the direction of motion of the supporting elements (4).

6. A supporting device as claimed in claim 5, **characterised in that** two locking elements are arranged in the form of plates (18, 19) which are located in planes parallel with the printed circuit board (1) and are displaceable in their respective planes and which have holes (22, 23, 24) through which the supporting elements (4) run so that, when the plates are displaced relative to each another, the supporting elements are clamped and locked.

7. A supporting device as claimed in claim 6, **characterised in that** in connection with each hole (22), there is arranged a resilient frictional element (25), which, when the plates are displaced relative to each another, clamp and lock the supporting elements.

8. A supporting device as claimed in claim 7, **characterised in that** the frictional elements are rubber plugs (25).

9. A supporting device as claimed in any one of claims 5-8, **characterised in that** the locking elements (18, 19) are displaceable by pneumatic action.

10. A supporting device as claimed in any one of the preceding claims, **characterised in that** the supporting elements (4) comprise hollow, stationary supports (11) and hollow pins (13) which are closed at one end (13a), the pins (13) being arranged to move along the support (11) and transversely of the plane of the printed circuit board (1).

11. A supporting device as claimed in claim 10, **characterised in that** the pins in their lower part have an abutment means, preferably a flange (15), which restricts the freedom of motion of the pins by abutting, in a predetermined projected position, against an abutment (20a) intended therefor.

## Patentansprüche

1. Eine Stützvorrichtung (2), welche zum Bestücken einer Leiterplatte (1) mit Bauteilen (3) dient, umfassend eine Mehrzahl langgestreckter Stützelemente (4), welche quer zur Leiterplattenebene angeordnet sind um die Leiterplatte wärend des Bestückens mit Komponenten zu stützen, und welche in Richtung der Leiterplatte (1) bewegbar und nachgiebig verschiebar ausgebildet sind um eine Halterung zur Stützung der Leiterplatte (1) zu bilden, **dadurch gekennzeichnet, dass**, abhängig von der Topographie der Leiterplatte (1), die Stützelement in jeder gewünschten Stellung arretiert werden können.

2. Eine Stützvorrichtung nach Anspruch 1, **dadurch gekennzeichnet, dass** die Stützelemente (4) dazu geeignet sind durch die Einwirkung eines Fluides, vorzugsweise eines Flüssigkeitsdruckes oder Gasdruckes, in Richtung Leiterplatte verschiebar zu sein.

3. Eine Stützvorrichtung nach Anspruch 2, **dadurch gekennzeichnet, dass** das Fluid ein Gas, und bevorzugt Druckluft, ist.

4. Eine Stützvorrichtung nach Anspruch 2 oder 3, **dadurch gekennzeichnet, dass** die Stützelemente mit einem gemeinsamen, geschlossenen Raum (6, 16) in Verbindung stehen, so dass wenn dieser Raum mit Fluiddruck beaufschlagt wird, sich alle Stützelemente unter Einwirkung des Druckes aufwärts in Richtung Leiterplatte (1) bewegen.

5. Eine Stützvorrichtung nach einem der vorhergehenden Ansprüche, **gekennzeichnet durch** mindestens ein Arretierelement (18, 19), welches im wesentlichen quer zur Bewegungsrichtung der Stützelemente (4) verschiebbar ist.

6. Eine Stützvorrichtung nach Anspruch 5, **dadurch gekennzeichnet, dass** zwei Arretierelemente in Form von Platten (18, 19) in Ebenen parallel zur Leiterplatte (1) angeordnet sind, in ihren jeweiligen Ebenen verschiebbar sind und mit Bohrungen (22, 23, 24) versehen sind, die von den Stützelementen (4) durchsetzt werden, so dass wenn die Platten relativ zueinander verschoben werden, die Stützelemente festgeklemmt und arretiert werden.

7. Eine Stützvorrichtung nach Anspruch 6, **dadurch gekennzeichnet, dass** jeder Bohrung (22) ein elastisches Reibungselement (25) zugeordnet ist, welches die Stützelemente festklemmt und arretiert wenn die Platten relativ zueinander verschoben werden.

8. Eine Stützvorrichtung nach Anspruch 7, **dadurch gekennzeichnet, dass** die Reibungselemente (7) Gummistöpsel (25).

9. Eine Stützvorrichtung nach einem der Ansprüche 5 bis 8, **dadurch gekennzeichnet, dass** die Arretierelemente (18, 19) durch Druckluft verschiebbar sind.

10. Eine Stützvorrichtung nach einem der vorhergehenden Ansprüche, **dadurch gekennzeichnet, dass** die Stützelemente (4) hohle, unbewegliche Stützen (11) und hohle, an einem Ende (13a) verschlossene, Stifte (13) umfassen, wobei die Stifte (13) so angeordnet sind, dass sie sich entlang der Stütze (11) und quer zur Ebene der Leiterplatte (1) bewegen.

11. Eine Stützvorrichtung nach Anspruch 10, **dadurch gekennzeichnet, dass** die Stifte in ihrem unterem Teil ein Anschlagmittel, vorzugsweise einen Flansch (15), aufweisen, welches die Bewegungsfreiheit der Stifte beschränkt, indem es in einer vorbestimmten, projektierten Position an einem zu diesem Zwecke vorgesehenen Anschlag (20a) anschlägt.

## Revendications

1. Dispositif de maintien (2) servant au montage de composants (3) sur une carte à circuits imprimés (1), comportant plusieurs éléments de maintien allongés (4) disposés transversalement par rapport au plan de la carte à circuits imprimés de manière à maintenir cette dernière lors du montage des composants, et adapté pour être mobile et se déplacer de façon élastique en direction de la carte à circuits imprimés (1) de manière à constituer un ensemble de maintien de la carte à circuits imprimés, **caractérisé en ce que** les éléments de maintien (4) peuvent être bloqués dans toute position voulue en fonction de la topographie de la carte à circuits imprimés (1).

2. Dispositif de maintien selon la revendication 1, **caractérisé en ce que** les éléments de maintien (4) sont adaptés pour être déplacés en direction de la carte à circuits imprimés par l'action d'un fluide, et de préférence par la pression d'un liquide ou la pression d'un gaz.

3. Dispositif de maintien selon la revendication 2, **caractérisé en ce que** le fluide est un gaz, de préférence de l'air comprimé.

4. Dispositif de maintien selon la revendication 2 ou 3, **caractérisé en ce que** les éléments de maintien (4) sont mis en communication avec un même volume fermé (6, 16) de sorte que, lorsque ce volume est soumis à la pression d'un fluide, cette pression fait monter l'ensemble des éléments de maintien en direction de la carte à circuits imprimés (1).

5. Dispositif de maintien selon l'une des revendications précédentes, **caractérisé par** au moins un élément de blocage (18, 19) monté mobile essentiellement dans le sens transversal par rapport au sens de déplacement des éléments de maintien (4).

6. Dispositif de maintien selon la revendication 5, **caractérisé en ce que** deux éléments de blocage se présentent sous la forme de plaques (18, 19) s'étendant dans des plans parallèles à la carte à circuits imprimés (1), pouvant se déplacer dans leurs plans respectifs, et possédant des orifices (22, 23, 24) traversés par les éléments de maintien (4) de sorte que, lors du déplacement des plaques l'une par rapport à l'autre, les éléments de maintien soient serrés et bloqués.

7. Dispositif de maintien selon la revendication 6, **caractérisé en ce qu'**un élément élastique de frottement (25) associé à chaque orifice (22) vient serrer et bloquer les éléments de maintien lors du déplacement des plaques l'une par rapport à l'autre.

8. Dispositif de maintien selon la revendication 7, **caractérisé en ce que** les éléments élastiques sont des bouchons en caoutchouc (25).

9. Dispositif de maintien selon l'une des revendications 5 à 8, **caractérisé en ce que** les éléments de blocage (18, 19) sont déplaçables par action pneumatique.

10. Dispositif de maintien selon l'une des revendications précédentes, **caractérisé en ce que** les éléments de maintien (4) comportent des supports creux immobiles (11) et des tiges creuses (13) dont une extrémité (13a) est obturée, les tiges (13) étant adaptées pour se déplacer longitudinalement sur chaque support (11) et transversalement par rapport au plan de la carte à circuits imprimés (1).

11. Dispositif de maintien selon la revendication 10, **caractérisé en ce que** les tiges possèdent dans leur partie inférieure un moyen formant butée, de préférence un collet (15), qui limite la course des tiges en venant buter, dans une position projetée déterminée, contre une butée (20a) prévue à cet effet.
